# EUROPÄISCHE PATENTANMELDUNG

(11) **EP 1 821 333 A1**
(43) Veröffentlichungstag der Anmeldung: **22.08.2007**
(21) Anmeldenummer: 07405021.2
(22) Anmeldetag: 25.01.2007
(51) Int. Cl.: H01J 37/34, C23C 14/34, C23C 14/00

(54) **Bauteil, Vorrichtung und Verfahren zur Herstellung eines Schichtsystems**

(30) Priorität: 16.02.2006 EP 06405071
(71) Anmelder: Sulzer Metco AG, 5610 Wohlen (CH)
(72) Erfinder: Beele, Wolfram, 40883 Ratingen (DE); Schmid, Richard K., Dr., 8500 Gerlikon (CH)
(74) Vertreter: Sulzer Management AG

(57) **Zusammenfassung**

Die Erfindung betrifft ein Bauteil, sowie eine zugehörige Beschichtungsvorrichtung und Verfahren, umfassend einen Grundkörper (1), insbesondere einen metallischen Grundkörper, welcher zumindest eine Nickel- und/oder Kobaltbasislegierung umfasst, sowie einem unmittelbar auf dem Grundkörper (1) angeordneten Schichtsystem. Das Schichtsystem umfasst eine Haftvermittlerschicht (2) sowie eine auf der Haftvermittlerschicht (2) angeordnete Wärmedämmschicht, umfassend eine TGO-Schicht (3), insbesondere eine langsam anwachsende Aluminiumoxidschicht und/oder Chromoxidschicht, sowie zumindest eine oxidkeramische Schicht (4), die unmittelbar auf der TGO-Schicht angeordnet ist, und eine auf der oxidkeramischen Schicht (4) angeordnete Deckschicht (5) aus einem A₂E₂O₇ Pyrochlor. A umfasst vorzugsweise ein Lanthanid, insbesondere Gadolinium und E vorzugsweise Zirkon, sowie insbesondere Lanthanzirkonat, und/oder eine Perowskitphase. Die Schichtdicken der oxidkeramischen Schicht (4), und der Deckschicht (5), betragen zusammen zwischen 50 µm und 2 mm, insbesondere zusammen zwischen 100 µm und 500 µm.

## Beschreibung

Die Erfindung betrifft ein Verfahren zur Herstellung eines Schichtsystems, welches insbesondere mehrlagige Wärmedämmschichten für hochtemperaturbelastete Bauteile umfasst, wie beispielsweise Gasturbinenschaufeln, sowie einer zugehörigen Vorrichtung, wobei neue Schichtmaterialien und -Systeme zum Einsatz kommen, die eine reduzierte Wärmeleitfähigkeit aufweisen.

Die Erfindung betrifft insbesondere ein Bauteil, eine Beschichtungsvorrichtung sowie ein Verfahren zur Beschichtung eines Grundkörpers mit einem Schichtsystem. Das Verfahren umfasst vorzugsweise ein PVD-Verfahren, insbesondere ein HS-PVD - Verfahren, welches auch unter der Bezeichnung reaktives Gasflusssputtern bekannt ist.

Im Stand der Technik gemäss EP 1591550, wird ein Schichtsystem offenbart, welches ein Substrat, einen Haftvermittler, eine TGO Schicht, eine yttrium-(teil-) stabilisierte Zirkonoxidschicht sowie eine Deckschicht aus einer Zirkonoxidbasiskeramik sowie zumindest ein anderes Element aus der Gruppe La, Ce, Pr, Nd, Sm, Eu , Gd, Tb, Dy, Ho, Er, Tm, Yb, Lu, Sc, In, Y, Mo, C, sowie Oxide der Seltenen Erden umfasst.

Verschiedene Forschungsprojekte haben gezeigt, dass die zur thermischen Leitfähigkeitsreduktion eingesetzten Materialien gemäss der Offenlegungsschriften EP0848077, US6231991, EP1577499, US6110604, US6376015 in aller Regel als Mehrlagenschicht aufgebracht werden müssen, um eine ausreichende Haftvermittlung zu gewährleisten.

Weiterhin wurde in US6110604 herausgefunden, dass zusätzliche Zwischenlagen ein günstiges Wärmereflexionsverhalten aufweisen. Diese Zwischenlagen weisen teilweise Ansammlungen von Atomgitterleerstellen auf, wodurch sich Hohlräume ausbilden.

Aus der US 5,238,752 ist ein Wärmedämmschichtsystem mit einem intermetallischen Haftvermittlungsüberzug bekannt. Das Wärmedämmschichtsystem ist auf einen metallischen Grundkörper aufgebracht, insbesondere einer Ni- oder Co-Superlegierung für eine Flugtriebwerksschaufel. Unmittelbar auf diesen metallischen Grundkörper ist eine intermetallische Haftvermittlungsschicht, insbesondere aus einem NickelAluminid oder einem Platin-Aluminid aufgebracht. An diese Haftvermittlungsschicht schliesst sich eine dünne keramische Schicht aus Aluminiumoxid an, auf die die eigentliche Wärmedämmschicht, insbesondere aus mit Yttriumoxid stabilisierten Zirkonoxid, aufgetragen ist. Diese keramische Wärmedämmschicht aus Zirkonoxid hat eine stabförmige Struktur, wobei die stabförmigen Stengel im wesentlichen senkrecht zur Oberfläche des Grundkörpers gerichtet sind. Hierdurch soll eine Verbesserung der zyklischen thermischen Belastungsfähigkeit gewährleistet sein. Die Wärmedämmschicht wird mittels eines Elektronenstrahl-PVD (Physical Vapour Deposition) -Verfahrens auf den Grundkörper abgeschieden, wobei mit einer Elektronenstahlkanone aus einem metalloxidischen Körper Zirkon- und Yttriumoxide verdampft werden. Das Verfahren wird in einer Vorrichtung durchgeführt, in der der Grundkörper auf eine Temperatur von etwa 950 °C bis 1000° C vorgeheizt wird. Der Grundkörper wird während des Beschichtungsvorganges in dem Strahl aus Metalloxid rotiert. Angaben über die stabförmige Kornstruktur sowie deren Eigenschaften sind der US 5,238,752 nicht entnehmbar, also mit dem dort beschriebenen Verfahren nicht gezielt herstellbar. Das Elektronenstrahl-PVD-Verfahren zur Herstellung keramischer Überzüge mit einer stabförmigen Kornstruktur ist weiterhin in der US 5,087,477 sowie der US 5,262,245 beschrieben, wobei die Abscheidung von Zirkonoxid auf einem Grundkörper in einer sauerstoffangereicherten Vakuumatmosphäre erfolgt.

Weitere Verfahren und Beispiele zum Aufbringen eines Wärmedämmschichtsystems auf eine Gasturbinenschaufel sind in der US 5,514,482 sowie der US 4,405,659 beschrieben. Gemäss der US 4,405,659 soll es mit dem Elektronenstrahl- PVD-Verfahren möglich sein, eine Wärmedämmschicht aus mit Yttriumoxid teilstabilisierten Zirkonoxid aufzubringen, welches eine Schichtdicke von etwa 125 µm aufweist und eine stengelförmige Struktur besitzt. Die mittlere Querschnittsfläche eines Stengels soll in der Grössenordnung von 6,5 µm² betragen. Allerdings ist das Elektronenstrahl- PVD-Verfahren mit einem erheblichen Verfahrensaufwand verknüpft, welche unter anderem durch die Kontrolle des Schmelzpools, der Erfordernisse des zwingenden Arbeitens im Hochvakuumbereich, sowie nicht zuletzt durch die Führung des Elektronenstrahls selbst bedingt sind.

In der WO 93/18199 A1 wird ebenfalls das Beschichten metallischer Bauteile, insbesondere Gasturbinenschaufeln aus einer Superlegierung, aus einem Verbundsystem mit einer Haftschicht und einer Wärmedämmschicht beschrieben. Das Aufbringen der Wärmedämmschicht erfolgt hierbei mit dem EB-PVD Verfahren und weist alle Nachteile desselben auf, wie einen erheblichen Verfahrensaufwand durch Schmelzpoolkontrolle, Hochvakuumumgebung und Führung des Elektronenstrahls.

In der DD 2 94 511 AS wird ein "Verfahren und Vorrichtung zum reaktiven Gasflusssputtern" offenbart. Gemäss des darin beschriebenen Verfahrens wird ein Inertgas, insbesondere Argon, durch eine Hohlkathode geführt, in deren Inneren eine Anode angeordnet ist, so dass eine Ionisation der Argon-Atome stattfindet. Diese treffen auf der Kathode auf, wodurch Kathodenmaterial in den Innenraum der Hohlkathode gelangt und mit dem Inertgasstrom aus dieser herausgeführt wird. Bei dem Kathodenmaterial handelt es sich um reines Metall, welchem ausserhalb der Hohlkathode Sauerstoff zugeführt wird, so dass eine vollständige Oxidation des Metalls, insbesondere Zirkoniums, stattfindet. Der Partialdruck des zugeführten Sauerstoffs liegt hierbei in der Grössenordnung von 10⁻⁴ Pa. Der gesamte dynamische Druck in der Umgebung des zu beschichtenden Halbleiters beträgt etwa 13 Pa bis 24 Pa. Die Abscheidungsrate beträgt etwa 15 nm/min, wobei das Substrat eine Temperatur von etwa 400 °C aufweist. Die Hohlkathode ist als zylindrisches Rohr aus Zirkonium mit einem Reinheitsgrad von 99,7%, ausgebildet. Diese Abscheidungsrate liegt allerdings nicht in einem für eine industrielle Anwendungen interessanten Bereich, da sich die Beschichtung von grossen Oberflächen schon aus Gründen der Zeitdauer für die Herstellung einer Beschichtung einer einzigen Schicht als wenig wirtschaftlich erweist.

Eine alternative Ausbildung der Hohlkathode zur Erreichung einer grösseren Beschichtungsfläche und einer grösseren Beschichtungsrate ist in dem Artikel "High rated desposition of alumina films by reactive gas flow sputtering" von T. Jung und A. Westphal, in Surface and Coatings Technology, 59, 1993, Seiten 171 bis 176 (hierzu korrespondiert die DE 42 35 953 A1), beschrieben. Die angegebene Hohlkathode ist linear aufgebaut in dem Sinne, dass in einem Gehäuse Platten aus Zirkonium nebeneinander angeordnet sind. Zwischen jeweils zwei benachbarten Platten ist ein Inertgasstrom hindurchführbar, so dass sich zwischen benachbarten Platten ein Plasma aus Inertgasatomen bildet. Die Platten können zudem eine Kühlungseinrichtung, insbesondere Kühlkanäle, aufweisen. Mit der Hohlkathode wurden Testkörper aus Silizium, rostfreiem Stahl und Glas beschichtet und die Festigkeit der Aluminiumoxidschicht bei bis zu 200 °C getestet. Aussagen über die Struktureigenschaften der Oxidschichten hinsichtlich Kristallitgrösse und - orientierung sind in den beiden genannten Artikeln nicht enthalten.

All diesen in den oben genannten Offenlegungsschriften dokumentierten Entwicklungen ist gemein, dass die Prozessführung hinsichtlich Materialangebot und kontaminations- und /oder störstellenfreien Zwischenlagen zwischen den Lagen an Komplexität deutlich zunimmt, da diese Lagen idealerweise in einer einzigen Vakuumkammer hintereinander abgeschieden werden.

Daher besteht Bedarf an einem Verfahren und einer Vorrichtung, die bei ökonomisch umsetzbarem Aufwand die Möglichkeit bereitstellen, bei maximal möglicher freier Wahl der Materialkombinationen diese insitu abzuscheiden.

In weiterer Folge soll das Beschichtungsverfahren innerhalb einer kürzeren Zeitdauer abgeschlossen sein, was den Einsatz von einem Verfahren erforderlich macht, das eine höhere Schichtbildungsrate erlaubt.

Diese Zielsetzung führt zur Weiterentwicklung der aus PCT/DE97/02152 bekannten Gasfluss-PVD Technik zur Herstellung von keramischen Schichten auf Gasturbinenbauteilen. Ein Problem, welches mit dem dort beschriebenen Verfahren verknüpft ist, ist die Begrenzung auf eine einzige Wärmedämmschicht. Die Verwendung einer einzigen Wärmedämmschicht aus einem einzigen Material, wie dem ebendort offenbarten Yttriumoxidteilstabilisierten Zirkonoxid besteht darin, dass die derart beschichteten Bauteile für viele Anwendungen im Hochtemperaturbereich eine unzureichend reduzierte Wärmeleitfähigkeit aufweisen. Zudem ist es bei Verwendung einer einzigen Wärmedämmschicht nicht auszuschliessen, dass der Wärmeübergang durch Strahlung einen relativ grossen Anteil des Gesamtwärmeübergangs ausmacht. Gemäss EP-A-1273680 sind insbesondere keramische Materialien bezüglich Wärmestrahlung insbesondere bei hohen Temperaturen transluzent, was zur Folge hat, dass das Bauteil durch die Strahlung im Betrieb zuviel Wärme aufnimmt, die durch Kühlung nicht oder nur in ungenügender Weise abgeführt werden kann. Zudem ist es aus konstruktiven Gründen nicht immer möglich, den Substratanteil des Bauteils zu kühlen.

Aufgabe der Erfindung ist es, ein Bauteil, insbesondere eine Gasturbinenschaufel, mit einer eine hohe Beständigkeit gegenüber hohen thermischen Wechselbelastungen aufweisenden Wärmedämmschicht anzugeben, die insbesondere aus mehreren Lagen bestehen soll. Eine weitere Aufgabe der Erfindung besteht darin, eine Vorrichtung sowie ein Verfahren zur Herstellung eines solchen Bauteiles mit einer entsprechenden keramischen Wärmedämmschicht anzugeben, wobei verschiedene Lagen der Wärmedämmschicht in einer einzigen Anlage unter Verwendung mehrerer Quellen in beliebiger Reihenfolge abgeschieden werden können.

Eine weitere Aufgabe der Erfindung besteht darin, eine Kathodenanordnung vorzusehen, die insbesondere eine Schicht zur Erzeugung einer Haftvermittlerschicht umfasst.

Die Aufgabe wird dadurch gelöst, dass ein Bauteil, umfassend einen Grundkörper, insbesondere einen metallischen Grundkörper, welcher zumindest eine Nickel- und/oder Kobaltbasislegierung umfasst, sowie einem unmittelbar auf dem Grundkörper angeordneten Schichtsystem erhalten wird, Das Schichtsystem umfasst eine Haftvermittlerschicht sowie eine auf der Haftvermittlerschicht angeordnete Wärmedämmschicht. Die Wärmedämmschicht umfasst eine TGO-Schicht (thermisch gewachsene Oxidschicht), insbesondere eine langsam anwachsende Aluminiumoxidschicht und/oder Chromoxidschicht, sowie zumindest eine oxidkeramische Schicht, die unmittelbar auf der TGO-Schicht angeordnet ist, und eine auf der oxidkeramischen Schicht angeordnete Deckschicht aus einem A₂E₂O₇ Pyrochlor, wobei A vorzugsweise ein Element der Lanthanreihe, insbesondere auf der Basis von Gadolinium (Gd), und E vorzugsweise Zirkon (Zr), sowie insbesondere Lanthanzirkonat, oder eine Perowskitphase umfassen. Als Grundkörper ist somit zumindest ein Substrat vorgesehen, welches sich in einer Beschichtungskammer befindet, welche zumindest eine Vakuumerzeugungseinrichtung umfasst, sowie eine Vorrichtung zur Aufnahme eines zu beschichtenden Substrats wobei eine zur Herstellung mehrerer Schichten geeignete Quelle und/oder eine Mehrzahl von Quellen in der Beschichtungskammer angeordnet ist/sind und/oder die Quellen Mittel aufweisen, um die Herstellung mehrerer Lagen der Wärmedämmschicht zu ermöglichen, wodurch der Insitu Auftrag einer Mehrzahl von Lagen einer Wärmedämmschicht in der Beschichtungskammer ermöglicht wird. Das erfindungsgemässe Bauteil, insbesondere eine Gasturbinenschaufel, weist einen Grundkörper, eine Haftvermittlerschicht, eine TGO-Schicht und eine darauf angeordnete keramische Wärmedämmschicht, die eine oxidkeramische Schicht mit einer Stengelstruktur mit Keramikstengeln umfasst, wobei die Keramikstengel im wesentlichen überwiegend normal zur Oberfläche des Grundkörpers gerichtet sind. Auf der oxidkeramischen Schicht wird eine Deckschicht aufgetragen, vorzugsweise durch ein reaktives Gasflusssputterverfahren.

Das Bauteil wird mit einer Beschichtungsvorrichtung zur Herstellung eines Schichtsystems auf einem Grundkörper hergestellt, wozu ein Verfahren zur Beschichtung eines Grundkörpers mit einem Schichtsystem zum Einsatz kommt, welches insbesondere unter Vakuum abläuft. Die Prozessparameter, wie Vakuumdruck, Sauerstoffpartialdruck, Volumenstrom des Inertgases werden so gewählt, dass die oben genannte Stengelstruktur entsteht. Die Schichtdicken der oxidkeramischen Schicht und der Deckschicht zusammen betragen zwischen 50 µm und 2 mm, insbesondere zwischen 100 µm und 500 µm. Weiterhin vorteilhaft ist es, insbesondere im Hinblick auf eine Lebensdauerverlängerung und Anhaftung der oxidkeramischen Schicht an den Grundkörper, eine chemische Anbindung der oxidkeramischen Schicht an die metallische Haftschicht herzustellen. Dies wird beispielsweise durch eine dünne Schicht aus einem Aluminiumoxid, insbesondere Al₂O₃ erreicht. Als Vermittlerschicht eignet sich ebenfalls eine Schicht aus einer ternären Al-Zr-O-Verbindung oder einer Al-O-N-Verbindung. Die ternäre AI-Zr-O-Verbindung, z. B. AlZrO₃ eignet sich vorzugsweise zur Anbindung einer oxidkeramischen Schicht, die Zirkonoxid enthält. Bei anderen oxidkeramischen Schichten, die insbesondere Magnesium-Zirkonoxid-Spinelle enthalten, können entsprechend andere Spinelle Anwendung finden. Weiterhin geeignet ist eine Schicht aus Aluminiumnitrid oder einer Verbindung (Mischschicht) aus Aluminiumnitrid und Aluminiumoxid.

In einer vorteilhaften Ausgestaltung des Bauteils umfasst die oxidkeramische Schicht eine Zirkonoxidschicht insbesondere eine gradierte Zirkonoxidschicht und/oder enthält einen Stabilisator, wie insbesondere ein Yttriumoxid, wie insbesondere Y₂O₃ und/oder ein Zirkonoxid , wie insbesondere ZrO₂, ein Hafniumoxid, wie insbesondere HfO₂ oder ein Mischoxid der beiden Komponenten, das durch ein Yttriumoxid, wie insbesondere Y₂O₃ teilstabilisiert vorliegt. Die oxidkeramische Schicht weist vorzugsweise eine metallkeramische Substanz, insbesondere ein Zirkonoxid wie ZrO₂, auf. Dieses Metalloxid ist vorzugsweise zur Vermeidung einer Phasenwandlung bei hohen Temperaturen mit einem Stabilisator, wie einem Yttriumoxid, insbesondere Y₂O₃ hergestellt. Das Zirkonoxid ist vorzugsweise mit einem Gehalt von 3 Gew.-% bis 12 Gew.-%, insbesondere 8 Gew.-%, Yttriumoxid versetzt. In einer gradierten Zirkonoxidschicht liegt das Zirkonoxid in lokalen Bereichen in unterschiedlicher Konzentration vor. Diese lokalen Bereiche können Zwischenlagen entsprechen, aber auch unterschiedliche Gefügestrukturen darstellen, die in einer Schicht koexistieren. Derartige gradierte Schichten können zur weiteren Reduktion der Transluzenz der Zirkonoxidschicht für Wärmestrahlung dienen, sodass derartige gradierte Schichten einen wesentlichen Anteil zu der gesamten Wärmedämmung beitragen, beziehungsweise zu einer Erhöhung der Wärmedämmung führen.

In einer vorteilhaften Ausgestaltung des Bauteils ist die Haftvermittlerschicht als metallische oder intermetallische Haftvermittlerschicht ausgebildet, die insbesondere eine M₁CrAlY-Legierung enthält, wobei M₁ für zumindest eines der Elemente Eisen (Fe), Kobalt (Co), Nickel (Ni), Chrom (Cr), Aluminium (AI), Yttrium (Y) steht und/oder die Haftvermittlerschicht (2) zumindest eines der Elemente der Seltenen Erden, Hafnium (Hf), Tantal (Ta), Silizium (Si) und/oder ein Metallaluminid enthält, wobei das Metallaluminid NiAl, CoAl, TiAl, NiCrAl, CoCrAl, sowie ein PtM₂Al, wobei M₂ die Elemente Fe, Ni, Co, Cr oder Kombinationen derselben, insbesondere PtNiAl, PtNiCrAl, umfasst. Für eine gute Anbindung der keramischen Wärmedämmschicht an den metallischen Grundkörper, insbesondere aus einer Nickel- Basis-Legierung oder anderen zur Herstellung thermisch hochbelastbarer Bauteile geeigneter Legierungen, ist auf den Grundkörper eine metallische Haftschicht aufgetragen. Hinsichtlich der Schichtdicke sei auf die US 5,238,752, die US 4,321,310 sowie die US 4,321,311 verwiesen. Die metallische Haftschicht besteht vorzugsweise aus einer Legierung der Art MCrAlY, wobei M für eines oder mehrere der Elemente Eisen, Kobalt oder Nickel, Cr für Chrom, Al für Aluminium und Y für Yttrium oder eines der Elemente der Seltenen Erden stehen. Als Haftschicht eignet sich ebenfalls eine intermetallische Verbindung, insbesondere aus Nickelaluminid oder Platinaluminid.

In einer vorteilhaften Ausgestaltung des Bauteils ist eine erste oxidkeramische Schicht vorgesehen, die vorzugsweise eine Dicke im Bereich von 5 bis 50 µm aufweist, sowie eine erste Deckschicht, die vorzugsweise eine Dicke im Bereich von 5 bis 50 µm aufweist, Zudem ist zumindest eine weitere Schichtfolge von einer weiteren oxidkeramischen Schicht und/oder Deckschicht vorgesehen. Die Verwendung von mehreren Schichtfolgen ist vorteilhaft für die oben angegebenen Materialien zur thermischen Leitfähigkeitsreduktion, da die Haftvermittlung gegenüber einer einzelnen Schicht verbessert ist.

In einer vorteilhaften Ausgestaltung des Bauteils nach weist die oxidkeramische Schicht Keramikstengel mit einem Stengeldurchmesser von unter 2,5 µm, insbesondere zwischen 0,5 µm und 2,0 µm, auf. Durch eine oxidkeramische Schicht ist ein thermischer Schutz des insbesondere metallischen Grundkörpers gewährleistet. Bekannte keramische Strukturen sind allerdings noch gegenüber zyklischen thermischen Belastungen anfällig und neigen unter Umständen zu einem Auseinanderbrechen und/oder Enthaften. Durch eine Mikrostruktur mit Keramikstengeln geringeren Durchmessers als der bisher erreichbare Durchmesser wird die Beständigkeit gegenüber Temperaturwechselbeanspruchungen deutlich erhöht. Eine Mikrostruktur mit Keramikstengeln mit einem mittleren Stengeldurchmesser von unter 2,5 µm, insbesondere zwischen 0,5 µm und 2,0 µm, besitzt eine hohe Dehnungstoleranz und eine hohe zyklische Belastungsfähigkeit aufgrund ihrer Ausrichtung im wesentlichen senkrecht zur Oberfläche des Grundkörpers und der feinen Stengelstruktur. Hierdurch werden Unterschiede in den Wärmeausdehnungskoeffizienten des insbesondere metallischen Grundwerkstoffes und der keramischen Wärmedämmschicht gut ausgeglichen. Solche geringe Stengeldurchmesser können durch ein für hohen Temperaturen entwickeltes reaktives Gasflusssputter-Verfahren erzielt werden.

In einer vorteilhaften Ausgestaltung des Bauteils weist die oxidkeramische Schicht Keramikstengel mit einem Stengeldurchmesser in einem Bereich von 2,5 µm bis 50 µm auf. Eine oxidkeramische Schicht mit feiner Stengelstruktur von unter 2,5 µm mittlerem Stengeldurchmesser eignet sich besonders für einen thermischen Schutz von Bauteilen einer Gasturbine, die zyklischen Temperaturbelastungen von mehr als 1000 °C ausgesetzt sind. Hierzu zählen vor allem Gasturbinenschaufeln sowie Komponenten des Brennkammerbereichs einer Gasturbine, insbesondere als Hitzeschilde ausgebildete Flächen. Dies gilt sowohl für stationäre Gasturbinen für einen Einsatz in Kraftwerken sowie für Flugtriebwerksturbinen. Selbstverständlich eignet sich die erfindungsgemässe Wärmedämmschicht auch für andere, hohen thermischen Belastungen ausgesetzte Bauteile.

Daher ist das Bauteil gemäss einer vorteilhaften Ausgestaltung insbesondere als Turbinenschaufel, wie insbesondere eine Leit- oder Laufschaufel einer Gasturbine, oder als eine heissgasbeaufschlagte Komponente einer Gasturbine, insbesondere ein Hitzeschild, ausgebildet.

Die Aufgabe der Erfindung wird dadurch gelöst, dass eine Beschichtungsvorrichtung zur Beschichtung eines Grundkörpers mit einem vorher beschriebenen Schichtsystem
a) eine Halteeinrichtung zur Positionierung des Grundkörpers in einer vakuumdicht verschliessbaren Kammer,
b) eine Vakuumerzeugungseinrichtung zur Erzeugung eines Vakuums in der Kammer,
c) eine Quelle zur Bereitstellung von beschichtungsfähigem Schichtmaterial, wobei die Quelle insbesondere als Hohlkathodenanordnung ausgebildet ist, und
d) einer zusätzlichen separaten Beheizungseinrichtung zur Erwärmung des Grundkörpers,
umfasst. Die Quelle ist derart angeordnet, dass Schichtmaterial mittels eines Inertgasstroms von der Quelle zum Bauteil transportierbar ist. Die auf eine Beschichtungsvorrichtung zur Herstellung eines Schichtsystems auf einem Grundkörper gerichtete Aufgabe wird somit durch eine Vorrichtung gelöst, die eine Halteeinrichtung zur Positionierung des Grundkörpers in einer Vakuumkammer umfasst. In dieser Vakuumkammer befindet sich eine Quelle, wie insbesondere eine Hohlkathode, welche von einem Inertgas durchströmbar ist. Diese Kathodenanordnung umfasst ein Kathodenmaterial und eine Anode, eine der Halteeinrichtung zugewandte Gasauslassöffnung sowie eine Gaseinlassöffnung für Inertgas und eine zusätzliche, separate Beheizungseinrichtung zur Erwärmung des Grundkörpers. Das in die Kathodenanordnung strömende Inertgas, wie insbesondere Argon, wird dort ionisiert. Die Inertgasatome treffen auf der der Oberfläche der Kathode auf, wodurch Kathodenmaterial abgestäubt wird. Das abgestäubte Kathodenmaterial verlässt mit dem Inertgas die Kathodenanordnung in Richtung des Grundkörpers oder Substrats. Zwischen dem Austritt aus der Kathodenanordnung und dem Auftreffen auf das Substrat kann der Inertgasstrom mit einem Sauerstoffstrom in Kontakt gebracht werden, sodass das abgestäubte Kathodenmaterial im Strom oder beim Auftreffen auf den Grundkörper oxidiert wird. Insbesondere zur Oxidation des Zirkons und gegebenenfalls des beigemischten Yttriums ist in der Vorrichtung eine Oxidationsmittelzuführung ausserhalb der Hohlkathode vorgesehen, durch die Sauerstoff in entsprechenden Mengen zuführbar ist. Mit dem Gasstrom des Inertgases, insbesondere des Argons, werden die zerstäubten, als Metallionen, Metallatome und/oder Metall-Cluster vorliegenden Zirkonium- und Yttrium-Teilchen aus der Hohlkathodenanordnung heraustransportiert. Ausserhalb der Hohlkathode werden diese in einer eingestellten Sauerstoff-Reaktionsatmosphäre vollständig oxidiert. Dies geschieht durch eine Zuführung von Sauerstoff durch die Oxidationsmittelzuführung derart, dass in Verbindung mit dem Inertgasstrom ein Eindringen des Sauerstoffs in die Hohlkathode unterbunden wird, so dass eine Oxidation des Kathodenmaterials weitgehend vermieden werden kann. Die oxidierten Metall-Teilchen schlagen sich auf dem Grundkörper als metalloxidkeramische Wärmedämmschicht nieder. Die Oxidation kann auch unmittelbar nach dem Niederschlag auf der Oberfläche des Grundkörpers stattfinden. In einer vorteilhaften Ausgestaltung ist die Kathodenanordnung als Hohlkathodenanordnung ausgebildet, wobei ein Hohlköper als Träger für das im Inneren des Hohlkörpers angebrachte Kathodenmaterial dient. In einem weiteren Ausführungsbeispiel umfasst die Kathodenanordnung zumindest ein plattenförmiges Element, das aus Kathodenmaterial besteht oder auf dem Kathodenmaterial aufgetragen ist.

In einer vorteilhaften Ausgestaltung der Beschichtungsvorrichtung ist die Kathodenanordnung von einem Inertgas durchströmbar. Die Kathodenanordnung enthält ein Kathodenmaterial, insbesondere eine Legierung aus Zirkon, die insbesondere ein Stabilisatormetall, wie Yttrium, enthalten kann, wobei der Anteil des Stabilisatormetalls so bestimmt ist, dass in der oxidkeramischen Schicht der Anteil des Stabilisatormetalloxids auf einen Bereich von 3,0% bis 12,0%, insbesondere auf einen Bereich von 3,0% bis 8,0%, Gewichtsprozent des Anteils des Zirkonoxids einstellbar ist. Eine Oxidationsmittelzuführung für eine Oxidation des Kathodenmaterials ist ausserhalb der Kathodenanordnung vorgesehen. Die Quelle umfasst eine Anode, eine der Halteeinrichtung zugewandte Gasauslassöffnung sowie eine Gaseinlassöffnung für Inertgas. In der Kathodenanordnung, welche als Hohlkörper, insbesondere mit einem kreisförmigen oder einem rechteckigen Querschnitt ausgeführt ist, wird durch Anlegen einer Gleichspannung zwischen Kathode und Anode eine Glimmentladung erzeugt. Die Anode kann beispielsweise stabförmig ausgebildet und in der Kathode angeordnet sein oder ausserhalb, insbesondere die Kathode als Gehäuse umschliessend, angeordnet sein. Durch ein in der Kathode entstehendes Plasma ist in jedem Fall zwischen dem Plasma und der Kathode ein so grosser Spannungsabfall vorhanden, dass eine ständige Ionisation aufrechterhalten bleibt. Hierdurch wird durch die Gaseinlassöffnung eintretendes Inertgas innerhalb der Hohlkathode ionisiert. Die ionisierten Inertgasatome treffen auf die kathodisch geschalteten Metallflächen der Hohlkathoden auf, gleichsam einem Ionenbeschuss, und führen zu einer zumindest teilweisen Zerstäubung der Metallflächen. Das Kathodenmaterial besteht vorzugsweise aus einer Legierung aus Zirkon, wodurch durch den Ionenbeschuss Zirkonatome oder Zirkonatom-Cluster aus dem Kathodenmaterial herausgeschlagen werden. Entsprechend einer gewünschten Stabilisierung des anschliessenden oxidierten und auf dem Grundkörper abgeschiedenen Zirkons ist dem Kathodenmaterial ein Stabilisatormetall, wie Yttrium, beigemischt oder zulegiert. Das Kathodenmaterial weist dementsprechend ein vorgegebenes Flächen- oder Volumenverhältnis von metallischem Zirkon und Yttrium auf.

In einer vorteilhaften Ausgestaltung der Beschichtungsvorrichtung enthält das Kathodenmaterial eine Legierung aus Zirkon, insbesondere mit einem Stabilisatormetall, wie Yttrium, wobei der Anteil des Stabilisatormetalls so bestimmt ist, dass in der oxidkeramischen Schicht der Anteil des Stabilisatormetalloxids auf einen Bereich von 3,0% bis 12,0%, insbesondere auf einen Bereich von 3,0% bis 8,0%, Gewichtsprozent des Anteils des Zirkonoxids einstellbar ist. Für die Oxidation des Zirkons kann eine Oxidationsmittelzuführung ausserhalb der Hohlkathodenanordnung vorgesehen sein.

In einer vorteilhaften Ausgestaltung der Beschichtungsvorrichtung zur Erzeugung der Deckschicht wird insbesondere ein Kathodenmaterial mit einer Zusammensetzung verwendet, die auf die Zusammensetzung der Deckschicht abgestimmt ist. Gemäss eines ersten vorteilhaften Ausführungsbeispiels enthält das Kathodenmaterial ein Lanthanid, insbesondere Gadolinium und/oder Lanthan, und/oder Zirkon, wobei das Verhältnis der Anteile so bestimmt ist, dass in der oxidkeramischen Deckschicht die Zusammensetzung eines Pyrochlors und/oder eines Perowskits einstellbar ist.

Gemäss eines zweiten vorteilhaften Ausführungsbeispiels enthält das Kathodenmaterial ein Lanthanid, insbesondere Gadolinium und/oder Lanthan, und/oder Zirkon, insbesondere mit einem Stabilisatormetall, wie Yttrium, wobei das Verhältnis der Anteile so bestimmt ist, dass in der oxidkeramischen Deckschicht die Zusammensetzung eines Pyrochlors oder eines Perowskits mit Beimischungen eines Stabilisatoroxides, insbesondere Y₂O₃, einstellbar ist.

Das Kathodenmaterial kann auf der oder den Elektroden entweder schichtweise aufgetragen werden, sodass mit dem Kathodenmaterial einer Kathode eine oder mehrere Schichten auf dem Bauteil erzeugbar sind, insbesondere die oxidkeramische Schicht, sowie die Deckschicht und/oder die gradierte Zirkonoxidschicht, die auch als oxidkeramische Deckschicht fungieren kann.

Alternativ dazu kann je eine Kathode mit Kathodenmaterial nach einem der obengenannten Ausführungsbeispiele eingesetzt werden. Die Kathode wird dann im Verlauf des Beschichtungsverfahrens ausgetauscht, sodass für jede Schicht oder für verschiedene Schichtkombinationen jeweils Kathoden mit dem geeigneten Kathodenmaterial zum Einsatz kommen.

In einer vorteilhaften Ausgestaltung der Beschichtungsvorrichtung ist die Beheizungseinrichtung für eine Erwärmung des Grundkörpers auf über 800 °C, insbesondere auf 950 °C bis etwa 1050°C ausgelegt. Zur Erzielung der gewünschten Stengelstruktur erfolgt eine entsprechende Einstellung des Druckes innerhalb der Beschichtungsvorrichtung sowie der Temperatur, vor allem der Temperatur des Grundkörpers. Dieser wird über eine Beheizungseinrichtung auf eine Temperatur von über 800 °C, insbesondere auf 950°C bis etwa 1050°C, erwärmt.

In einer vorteilhaften Ausgestaltung der Beschichtungsvorrichtung ist eine Vakuumpumpeinrichtung zur Erzeugung eines Vakuums in einer vakuumdicht verschliessbaren Kammer von unter 1 mbar, insbesondere von 0,3 mbar bis 0,9 mbar vorgesehen. Mit der Beschichtungsvorrichtung zur Durchführung eines Hochgeschwindigkeits-Gasflusssputter-Verfahrens wird eine Entkopplung der Arbeitsatmosphäre für die Ionisation des Inertgases (Plasmaquelle) und des zu beschichtenden Bauteils erreicht. Mit diesem Gasflusssputter-Verfahren lassen sich sehr hohe Abscheidungsraten, von bis zu 100 µm/h und darüber erzielen, die den Einsatz dieses Verfahrens im industriellen Massstab ermöglichen. Gegenüber konventionellen PVD-Verfahren, insbesondere dem Elektronenstrahl-PVD-Verfahren, sind andere Wertebereiche der Kenngrössen, wie Druck des Restgases (Vakuumdruck, benötigtes Pumpniveau des Vakuumsystems), Arbeitsdruck sowie Verhältnis des Reaktivgases (Sauerstoff) zu den restlichen Arbeitsgasen gegeben. Die Atmosphäre an dem zu beschichtenden Bauteil kann für eine Durchführung des Verfahrens bei einem Restgasdruck von 10⁻³ mbar liegen, wobei die Obergrenze des Restdrucks in der Grössenordnung von 10⁻² mbar liegen kann. Der Arbeitsdruck am Bauteil insbesondere im Bereich der Hauptkammer der Beschichtungsvorrichtung kann in der Grössenordnung zwischen 0,2 bis 0,9 mbar liegen. Das Verhältnis des Reaktivgases (Sauerstoff) zu dem ionisierten Inertgas, insbesondere Argon, das bei den vorliegenden Bedingungen als Plasmagas vorliegt, kann im Bereich von 0,01 bis 0,04 liegen. Die Atmosphäre der Plasmaquelle ist von der Atmosphäre des Bauteils im wesentlichen entkoppelt und weist einen Restgasdruck in der Grössenordnung des Restgasdrucks an dem Bauteil auf. Der Arbeitsdruck der Gasströmung kann um etwa 0,02 mbar höher als der Arbeitsdruck an dem Bauteil sein. Durch die Gasausströmung der Quelle wird mithin der Arbeitsdruck am Bauteil, d. h. in der Hauptkammer des Beschichtungssystems, bestimmt. In der Kathodenanordnung liegt mithin ein Überdruck gegenüber der Hauptkammer vor. Das Verhältnis von Restgasbestandteilen, insbesondere Sauerstoff, zu dem ionisierten Inertgas (Plasmagas) liegt vorzugsweise unter 1%. Hierdurch kann die lonisationsquelle in dem oben dargelegten Ausführungsbeispiel die Hohlkathodenanordnung im Gleichstrom-Betrieb gefahren werden, da keine Oxidation der Beschichtungsquelle (Hohlkathode) mit einem instabilen Betriebszustand erfolgt. Hierdurch wird das Auftreten einer Glimmentladung sowie die Erzeugung von Lichtbogenplasmen aufgrund einer Oxidation des Kathodenmaterials vermieden. Gegenüber bekannten Vorrichtungen zur Durchführung von PVD- Verfahren, insbesondere dem Elektronenstrahl-PVD-Verfahren, ist somit ein deutlich höherer Restgasdruck möglich, was zu einem vereinfachten und kostengünstigeren Vakuumsystem führt. Der Restgasdruck bei den bekannten Anlagen zur Erreichung einer stengelförmigen Wärmedämmschicht liegt im Bereich von 10⁻⁶ bis 10⁻⁵ mbar. Der Arbeitsdruck liegt bei den konventionellen Verfahren im Bereich von 10⁻³ bis 10⁻² mbar mit einer technisch sinnvollen Obergrenze kleiner 0,1 mbar und somit deutlich unter dem beim reaktiven Gasflusssputter-Verfahren möglichen Arbeitsdruck. Zudem ist bei den bekannten PVD- Verfahren ein hohes Verhältnis von Reaktivgas (Sauerstoff) zu weiteren Arbeitsgasen, wie Argon, Helium, etc., von 10 : 1 oder höher erforderlich. Bei der erfindungsgemässen Vorrichtung und dem erfindungsgemässen Verfahren wird ein wesentlich niedrigeres Verhältnis benötigt, so dass auch die Zufuhreinrichtungen von Arbeitsgas und Reaktivgas deutlich einfacher und billiger ausführbar sind. Bei den bekannten PVD-Verfahren liegt zudem die Beschichtungsquelle ohne Entkopplung in der Hauptkammer und ist damit auch ungeschützt einer Oxidation ausgesetzt. Die erfindungsgemässe Vorrichtung kann somit ohne Hochfrequenzgeneratoren oder echtzeit-geregelten Gleichstromgeneratoren ausgeführt sein. Die Beheizungsvorrichtung ist hierbei vorzugsweise so ausgebildet, dass eine gleichmässige Erwärmung, insbesondere Volumenerwärmung, des Grundkörpers gegeben ist. Selbst an Stellen des Grundkörpers mit hoher Massenkonzentration und grossem Teilvolumen ist eine gleichmässige Ankeimtemperatur für den gesamten Grundkörper erreicht. Das Vakuum (Arbeitsdruck) innerhalb der Beschichtungsvorrichtung liegt vorzugsweise unter 1 mbar, insbesondere im Bereich zwischen 0,3 mbar bis 0,9 mbar, wie beispielsweise bei 0,5 mbar. Zur Einstellung des gewünschten Vakuums ist eine Vakuumpumpeinrichtung vorgesehen, die einen einfachen Aufbau, z. B. eine Roots-Pumpen-Ausführung, aufweisen kann. Gegenüber dem herkömmlichen Elektronenstrahl-PVD-Verfahren, bei dem zur Erzielung eines Hochvakuums eine Drehschiebervorpumpe sowie eine Diffusionspumpe vorzusehen sind, ist die Vakuumpumpeinrichtung des Gasflusssputter-Verfahrens wesentlich einfacher ausführbar.

In einer vorteilhaften Ausgestaltung der Beschichtungsvorrichtung ist die Halteeinrichtung beweglich, insbesondere drehbar gelagert, sodass eine kontinuierliche Hin- und Herbewegung und/oder Drehung, des Grundkörpers gegenüber der Gasauslassöffnung ermöglicht wird. Die Beschichtungsvorrichtung zeichnet sich insbesondere dadurch aus, dass um den Drehpunkt des Bauteils, wie beispielsweise einer Turbinenschaufel, mehrere Quellen positioniert werden, die durch einen Shutter oder Gasfluss ohne Plasma vor Kontamination geschützt werden und in den abwechslungsweise ein Plasma gezündet werden kann. Natürlich ist es prinzipiell auch möglich, eine der Lagen als Mix durch das gleichzeitige Beschichten aus mehreren Quellen zu erhalten. Alternativ kann natürlich auch ein Chargieren zwischen diskreten Vakuumkammern mit je einer Quelle erfolgen. Diese Variante ist denkbar, wenn das gesamte Schichtsystem, insbesondere umfassend die Haftvermittlerschicht, die als metallische Bondcoat-Lage ausgebildet sein kann, in einer Beschichtungsvorrichtung erzeugt werden soll und kontaminationsbedingt eine strikte Trennung zwischen Vakuumbetrieb für Schichten mit metallischem Anteil und reaktivem Betrieb im Vakuum mit Sauerstoffzufuhr erfolgen soll. Die metallische Bondcoat-Lage kann sowohl aus den Familien der MCrAlY, NiAl's, PtNiAl's, TiAl's sowie Kombinationen hieraus bestehen, es kann aber auch eine Direktbeschichtung der Keramiken auf geeignete Superlegierungen erfolgen. Vorteilhafterweise sollte die reaktive Ausbildung des TGO (Thermisch Gewachsenes Oxid), wie von EB-PVD Wärmedämmschichten, den sogenannten TBC-Schichten (Thermal Barrier Coating) bekannt ist, vorgesehen werden. Zur Erzielung einer möglichst gleichmässigen Beschichtung des Bauteils, insbesondere einer Gasturbinenschaufel, ist die Haltevorrichtung für eine Bewegung des Grundkörpers gegenüber der Gasauslassöffnung ausgebildet. Vorzugsweise umfasst die Halteeinrichtung einen Drehmechanismus, durch den eine kontinuierliche Drehung des Bauteils um seine Längsachse erfolgt.

Die Aufgabe wird dadurch gelöst, dass ein Verfahren zur Beschichtung eines Grundkörpers mit dem vorgehend beschriebenen Schichtsystem unter Vakuumbedingungen eingesetzt wird, bei welchem ein Inertgas in einer im wesentlichen sauerstofffreien Atmosphäre ionisiert wird, das ionisierte Inertgas mit einer Kathodenanordnung in Kontakt gebracht wird, welches dort aus einem Kathodenmaterial, insbesondere einem metallischen oder keramischen Kathodenmaterial, Atome und/oder Atomgruppen herauslöst, worauf die aus dem Kathodenmaterial herausgelösten Atome und/oder Atomgruppen mit dem Inertgas in Richtung des Grundkörpers mitgeführt werden und welchen vor Erreichen des Grundkörpers Sauerstoff zugeführt wird, so dass sich ein Metalloxid und/oder eine oxidkeramische Verbindung bildet, welche auf dem Grundkörper abgeschieden werden oder eine metallische oder keramische Verbindung auf dem Grundkörper abgeschieden wird und auf dem Grundkörper durch auftreffenden Sauerstoff zu einem Metalloxid oder einer oxidkeramischen Verbindung oxidiert wird, wobei der Grundkörper auf eine vorgegebene Ankeimtemperatur von über 800 °C, insbesondere in einem Bereich zwischen 950 °C und 1050 °C aufgeheizt wird.

Im vorhin beschriebenen Verfahren zur Beschichtung eines Grundkörpers unter Vakuum mit einer Wärmedämmschicht wird ein Inertgas in einer im wesentlichen sauerstofffreien Atmosphäre ionisiert. Dies erfolgt beispielsweise, indem das Inertgas durch eine Hohlkathode geführt und in dieser ionisiert wird. Die ionisierten Atome des Inertgases lösen aus einem metallischen Kathodenmaterial Metallatome und/oder Metallcluster heraus, die mit dem Inertgas aus der Hohlkathode herausgeführt und ausserhalb der Hohlkathode mit Sauerstoff zu einem Metalloxid oxidiert werden. Es ist ebenfalls möglich, dass sich Metall auf dem Grundkörper abscheidet und dort durch auftreffenden Sauerstoff oxidiert wird. Das Metalloxid wird auf dem Grundkörper abgeschieden, der mit einer separaten Beheizungsvorrichtung auf eine vorgegebene Ankeim- und Kondensationstemperatur aufgeheizt wird. Hierdurch wird eine Wärmedämmschicht aus einem Metalloxid auf dem Grundkörper hergestellt, die eine feine stengelförmige Mikrostruktur aufweist, wobei der mittlere Stengeldurchmesser bei unter 2,5 µm, insbesondere in einem Bereich zwischen 0,5 µm bis 2,0 µm liegen kann. Diese Wärmedämmschicht hat eine besonders gute Beständigkeit gegenüber thermomechanischen Wechselbelastungen, wie es insbesondere bei mit einem Heissgas beaufschlagten Teilen einer Gasturbinenanlage, wie einer Turbinenschaufel und lsolationskomponenten, besonders vorteilhaft ist.

Gegenüber bekannten Elektronenstrahl-PVD-Verfahren wird für die Herstellung der oxidkeramischen Schicht als Kathodenmaterial ein Reinmetall oder eine Legierung aus einem Hauptmetall und zumindest einem Stabilisatormetall verwendet. Hierfür eignet sich bevorzugt eine Legierung aus Zirkon mit Yttrium, wobei das Yttrium dem Zirkon in einer solchen Menge und Verteilung zugesetzt ist, dass eine Wärmedämmschicht aus mit Yttriumoxid teilstabilisiertem Zirkonoxid entsteht. Selbstverständlich eignen sich als Kathodenmaterial auch andere Metalle, die zu einem thermisch hochbeständigen Metalloxid führen, wie beispielsweise Magnesium-Zirkonoxid-Spinelle. Die Verwendung einer metallischen Kathode anstelle eines Körpers aus Metalloxid, wie er beispielsweise bei den bekannten Elektronstrahl- PVD-Verfahren verwendet wird, hat den Vorteil, dass die hergestellte Wärmedämmschicht wesentlich feinstrukturierter ist. Darüber hinaus wird durch einen vollreaktiven Oxidationsprozess der aus dem Kathodenmaterial herausgelösten metallischen Zerstäubungsmaterialien das Auftreten von Schichtfehlern vermieden, die beim Elektronenstrahl-PVD-Verfahren durch Fehler in dem Keramikkörper, wie inhomogene Porosität oder Fremdkörpereinflüsse, auftreten können. Zudem lässt sich gegenüber einem Keramikkörper das Kathodenmaterial einfacher und in höchster Reinheit herstellen.

Die Anbindung der Wärmedämmschicht aus Metalloxid erfolgt beispielsweise über die Ausbildung einer homogenen wachsenden Aluminiumoxid-Reaktionsschicht (Vermittlerschicht) zwischen der Wärmedämmschicht und einer Haftschicht aus einer Metallegierung der Art MCrAlY. Das reaktive Gasflusssputter-Verfahren unter Verwendung einer von einem Inertgas durchströmten Hohlkathodenanordnung hat zudem den Vorteil, dass es in einem relativ groben Vakuum mit ausreichender Abscheidung von Metalloxiden auf den Grundkörper durchgeführt werden kann. Gegenüber den bekannten Elektronenstrahl-PVD-Verfahren mit komplizierten Elektronenstrahlablenkungs- und -fokussierungsfunktionen zeichnet sich das beschriebene Verfahren durch eine einfache Regelung bzw. Steuerung der Prozessgrössen, wie Ankeimtemperatur, Vakuumdruck, Sauerstoffpartialdruck, Volumenstrom des Inertgases, Leistung der Hohlkathodenentladung aus. Die Bestimmung der zur Erreichung einer Struktur mit einem mittleren Stengeldurchmesser von unter 2,5 µm erforderlichen Prozessgrössen erfolgt anhand des Thornton-Diagramms zur PVD-Schichtstrukturausbildung, welches beispielsweise in Journal of Vacuum Science Technology, Vol. 11, 1974, Seiten 666 bis 670, von J.A. Thornton beschrieben ist. Hierin ist die Schichtstrukturausbildung in Abhängigkeit der Substrattemperatur, des Vakuumkammer-Gasdrucks und dem Schichtenenergiegehalt zur Aktivierung von Platzwechselprozessen beschrieben. Die Anode verschleisst nicht oder wesentlich langsamer als das Kathodenmaterial, da sie bei Anordnung im Gaseinlassbereich keiner Beschichtung oder Oxidation ausgesetzt ist. Verschleissteile wie die Anode oder das Kathodenmaterial können klein gehalten werden, insbesondere da die Anode innerhalb der Hohlkathode angeordnet ist, und somit einem direkten Beschuss von Elektronen oder Ionen nicht ausgesetzt ist. Die Anode kann zudem mit hohem Reinheitsgrad hergestellt werden.

Nach dem oben beschriebenen Verfahren wird insbesondere ein reaktives Gasflusssputterverfahren (HS-PVD) in Kombination mit einem Vakuumbogenverdampfungsverfahren und/oder Hohlkathodenverdampfungsverfahren, und/oder Niedervoltbogenverdampfungsverfahren und/oder Elektronenstrahlverdampfungsverfahren und/oder einem PVD Verfahren, wie insbesondere dem HF-PVD und/oder DC-PVD Verfahren und/oder einem APS und/oder LPPS und/oder TF-LPPS und/oder VPS verwendet.

Bei den PVD (physical vapour deposition) Verfahren handelt es sich um Verfahren, bei welchen Schichtmaterial durch Abscheidung aus der Dampfphase auf das Substrat aufgetragen wird. Dabei erfolgt die Erzeugung des Dampfes wie in dem Buch "Plasmabeschichtungsverfahren und Hartstoffschichten" von B. Rother, und J. Vetter, Leipzig, Dt. Verl. Für Grundstoffindustrie, 1992 beschrieben wird, nach einem der nachfolgenden Verfahren, welche die Vakuumbogenverdampfung, die Hohlkathodenbogenverdampfung, die Niedervoltbogenverdampfung oder eine Elektronenstrahlverdampfung als Verdampfungsverfahren umfassen oder mittels einer DC- oder HF- Entladung als reaktives Zerstäubungsverfahren, zu welchen das bevorzugt zu verwendende HS-PVD- Verfahren zu zählen ist. Beim Vakuumbogenverdampfungsverfahren erfolgt die die reaktive Verdampfung mittels eines Vakuumbogen-Verdampfers. Durch die Vakuumbogenentladung im Dampf des Kathodenmaterials wird das Kathodenmaterial ionisiert, tritt in den Gasraum ein und trifft dort auf das zu beschichtende Substrat. Bei einem Hohlkathodenbogenverdampfer (HKB) dient ein leistungsstarker Elektronenstrahl als Energieträger zur Erhitzung des Kathodenmaterials, wobei ein sogenanntes quasineutrales Plasma, das heisst, ein Gemisch aus Elektronen und Ionen jeweils gleicher Ladungsdichte erzeugt wird. Dieses Plasma wird auf eine Tiegelanode geleitet, welche zu verdampfendes Beschichtungsmaterial enthält. Von der Anode wird das verdampfte Beschichtungsmaterial auf das Substrat geleitet. Bei einem Niedervoltbogenverdampfer wird die Entladung in einem Arbeitsgas mit einer Brennspannung betrieben, die unterhalb der lonisierungsspannung des Arbeitsgases liegt. Die Kathode ist als Glühkathode ausgebildet und wirkt als Elektronenemitter durch Thermoemission entlang der Entladungsstrecke, wobei die derart generierten Ladungsträger als Ionen in einem Sputterverfahren, wie auch als Elektronen zum Verdampfen verwendet werden können. Ein weiteres Verfahren zur Metalldampfgenerierung für Beschichtungen ist die Elektronenstrahlverdampfung, bei welchem ein Elektronenstrahl auf eine dampfabgebende Oberfläche gerichtet wird. Insbesondere wird darunter das schon mehrmals erwähnte Elektronenstrahl-PVD-Verfahren (EB-PVD) Verfahren verstanden.

Bei den Zerstäubungsverfahren werden die freien Teilchen im Gegensatz zum Verdampfungsprinzip nicht aus der flüssigen Phase erzeugt. Die Energie und die Energieverteilung der gestäubten Teilchen unterscheiden sich demzufolge von den entsprechenden Werten verdampfter Teilchen. Abgestäubte Atome können nach Verlassen der Festkörperoberfläche die 10 bis 100fache kinetische Energie von verdampften Teilchen besitzen. Ein wesentlicher Vorteil der Feststoffzerstäubung gegenüber dem Verdampfungsprinzip liegt in der Möglichkeit, Legierungen oder auch Mehrkomponentenmaterialien abzustäuben und diese unter bestimmten Voraussetzungen als Schicht wieder abzuscheiden. Für die Zerstäubung von elektrisch leitfähigen Teilchen ist DC-Zerstäubungsverfahren besonders geeignet. Die Kathode dient als Target und ist gleichzeitig negative Elektrode zur Aufrechterhaltung der Glimmentladung. Auf der anderen Elektrode ist das Substrat angeordnet. Als Variante kann die Triodenzerstäubung angesehen werden, bei welcher die Anzahl der ionisierenden Elektronen vergrössert wird, indem eine zusätzliche Elektrode zum Einsatz kommt. Durch Überlagerung eines elektrischen mit einem magnetischen Feld steigt die lonisationswahrscheinlichkeit, wodurch man einen target- und substratunabhängigen Plasmagenerator erhält. Durch Beschleunigung der Ionen des Plasmas auf das Target, also die Quelle, wird das auf dem Target befindliche Schichtmaterial zerstäubt. Durch Optimierung der Magnetfeldführung gelangt man in den Bereich des Hochratezerstäubungsverfahrens (HS-PVD). Für elektrisch nichtleitende Teilchen im Target kommt das HF-Zerstäubungsverfahren zum Einsatz, wobei HF für Hochfrequenzeinrichtung steht. Mittels hochfrequenter Strahlung wird ein Gleichspannungspotential an der Elektrode erzeugt, indem die unterschiedliche Bewegungsfähigkeit von Elektronen während der positiven Halbwelle relativ zu den Ionen während der negativen Halbwelle ausgenützt wird. Eine weitere Variante stellt die reaktive Zerstäubung dar, bei welcher dem Inertgas eine Reaktivgaskomponente zugeführt wird.

Alternativ ist auch eine Verfahrenskombination von TF-LPPS ( (thin film low pressure plasma spraying) gemäss EP-A-1260602 oder WO-A -03087422 und dem hier beschriebenen Verfahren zur Erzeugung von Mehrlagensystemen denkbar. Mit dem LPPS-Dünnfilm-Prozess wird ein konventionelles LPPS-Plasmaspritzverfahren verfahrenstechnisch abgewandelt. Das Beschichtungsmaterial wird pulverförmig und mit einem Fördergas in das Plasma injiziert. Eine starke räumliche Ausdehnung des Plasmas führt zu einer "Defokussierung" des Pulverstrahls. Dabei wird das Pulver zu einer Wolke dispergiert und aufgrund einer hohen Enthalpie des Plasmas geschmolzen sowie gegebenenfalls teilweise oder vollständig verdampft. Das Beschichtungsmaterial gelangt gleichmässig verteilt auf eine weit ausgedehnte Oberfläche des Substrats. Es wird eine dünne Lage abgeschieden, deren Schichtdicke kleiner als 10 µm ist und die dank der gleichmässigen Verteilung eine dichte Abdeckung bildet. Durch einen mehrfachen Auftrag von dünnen Lagen kann gezielt eine dickere Beschichtung mit besonderen Eigenschaften hergestellt werden.

Eine solche Beschichtung ist als Funktionsschicht verwendbar. Auf einem Grundkörper, der das Substrat bildet, kann eine Funktionsschicht aufgebracht werden, die in der Regel verschiedene Teilschichten umfasst. Beispielsweise werden für Gasturbinen (stationäre Gasturbine oder Flugzeugtriebwerk), die bei hohen Prozesstemperaturen betrieben werden, die Schaufeln mit einer ersten ein- oder mehrlagigen Teilschicht beschichtet, so dass das Substrat beständig gegen Heissgaskorrosion wird. Eine zweite, auf der ersten Teilschicht aufgebrachte Beschichtung - aus keramischem Material - bildet eine Wärmedämmschicht. In der EP-A- 1 260 602 ist ein Verfahren zum Erzeugen eines derartigen wärmedämmenden Schichtsystems beschrieben, bei dem eine Mehrzahl von Einzelschichten (Sperrschicht, Schutzschicht, Wärmedämmschicht und/oder Glättungsschicht) durch eine wechselnde Einstellung von steuerbaren Prozessparametern in einem Arbeitszyklus aufgebracht werden können. Die Prozessparameter sind Druck sowie Enthalpie des Plasmas, Zusammensetzung des Prozessgases und Zusammensetzung sowie Applikationsform des Beschichtungsmaterials.

Anhand der in der Zeichnung dargestellten Ausführungsbeispiele werden das Bauteil, die Vorrichtung und das Verfahren zur Herstellung eines Schichtsystems auf einem Grundkörper näher erläutert. Es zeigen:

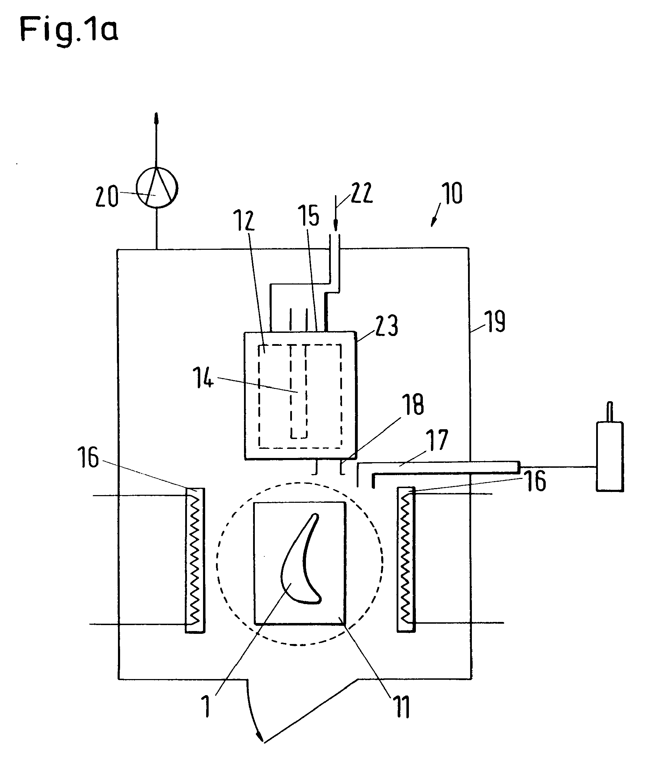

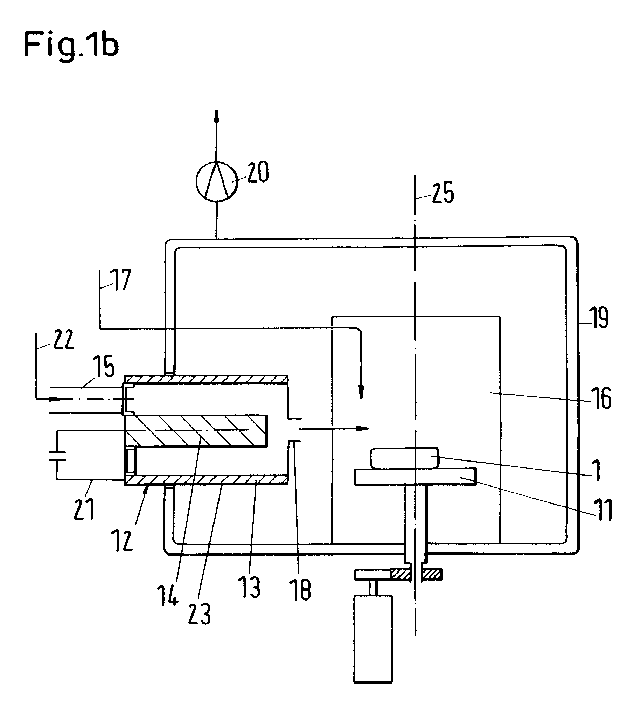

Fig. 1 a ein in einer Vorrichtung zur Beschichtung mit einer Wärmedämmschicht angeordnetes Bauteil in einer Ansicht von oben,
Fig. 1 b ein in einer Vorrichtung zur Beschichtung mit einer Wärmedämmschicht angeordnetes Bauteil in einer seitlichen Ansicht,
Fig. 2 einen Längsschnitt durch das Bauteil nach einem ersten Ausführungsbeispiel,
Fig. 3 einen Längsschnitt durch das Bauteil nach einem weiteren Ausführungsbeispiel.

In Fig. 1 ist schematisch und nicht massstäblich ein prinzipieller Aufbau einer Beschichtungsvorrichtung 15 zur Durchführung eines reaktiven Gasflusssputter-Verfahrens dargestellt. Die Beschichtungsvorrichtung 15 weist eine Kammer 19 auf, in dem durch eine Vakuumpumpeinrichtung 20 ein Vakuum von unter 1 mbar, insbesondere etwa 0,5 mbar, erzeugbar ist. Innerhalb der Kammer 19 ist eine Hohlkathodenanordnung 12 mit kreiszylindrischem Querschnitt angeordnet. Für die Beschichtung grosser Bauteile können mehrere solcher zylindrischer Hohlkathoden oder eine lineare Hohlkathode mit rechteckigem Querschnitt, die entlang einer Längsachse ausgerichtet sind/ist, verwendet werden. Innerhalb der Hohlkathode 12 ist eine stabförmige Anode 14 angeordnet, die über eine Gleichspannungsversorgung 21 mit der Hohlkathode 12 verbunden ist. Die Gleichspannungsversorgung 21 erzeugt beispielsweise eine Gleichspannung von 400 V bis 800 V, was zu einem Entladungsstrom von etwa 2 A führt. Die Hohlkathode 12 weist ein Kathodenmaterial 13 auf, welches als Hohlzylinder ausgebildet ist oder beispielsweise aus einzelnen die Innenwandung der Hohlkathodenanordnung 12 ausfüllenden Platten besteht. Die Hohlkathode 12 weist ein Aussengehäuse mit einer Gaseinlassöffnung 15 auf, die mit einer nicht dargestellten Gasversorgung verbunden ist, über die ein Inertgas 22, insbesondere Argon, in die Hohlkathode 12 eingeführt wird. Das Aussengehäuse 23 dient der Führung des Inertgasstroms, der Unterbindung des Eindringens von Reaktivgas in die Hohlkathode 12 und der Abschirmung von Kathodenpotential führenden Oberflächen, die nicht zerstäubt werden sollen, insbesondere nicht dargestellte Kühlplatten des Kathodenmaterials 13. Der Gaseinlassöffnung 15 gegenüberliegend hat die Hohlkathode 12 eine Gasauslassöffnung 18, aus der das Inertgas 22 nach Durchlaufen des Bereiches zwischen Kathodenmaterial 13 und Anode 14 aus der Hohlkathode 12 herausströmt. Geodätisch oberhalb der Gasauslassöffnung 18 ist mit einem Mündungsbereich eine Oxidationsmittelzuführung 17 angeordnet, durch die Sauerstoff in das Gehäuse 23 einführbar ist. Geodätisch oberhalb der Oxidationsmittelzuführung 17 ist ein Bauteil, also der Grundkörper 1, insbesondere eine Gasturbinenschaufel, in einer Halteeinrichtung 11 gehalten. Die Halteeinrichtung 11 ist über eine Zusatzspannungsversorgung mit der Hohlkathode 12 elektrisch verbindbar. Eine zwischen die Hohlkathode 12 und die Haltevorrichtung 11 respektive das Bauteil 1 anlegbare Gleichspannung bewirkt eine Oberflächenreinigung des Bauteils 1 durch ionisierte Inertgasatome. Die Halteeinrichtung 11 hat vorzugsweise eine nicht näher dargestellte Antriebsvorrichtung, wodurch eine kontinuierliche Drehung des Bauteils 1 um seine Längsachse 25 stattfindet. Geodätisch oberhalb des Bauteils 1 ist eine Beheizungseinrichtung 16 zur Beheizung des Bauteils über Wärmestrahlung und/oder Konvektion angeordnet. Die Beheizungseinrichtung 16 kann selbstverständlich je nach Anforderung auch auf gleichem geodätischem Niveau neben dem Bauteil 1 angeordnet sein. Ebenfalls können alle Konfigurationsangaben in umgekehrter geodätischer oder in horizontaler Anordnung ausgeführt werden.

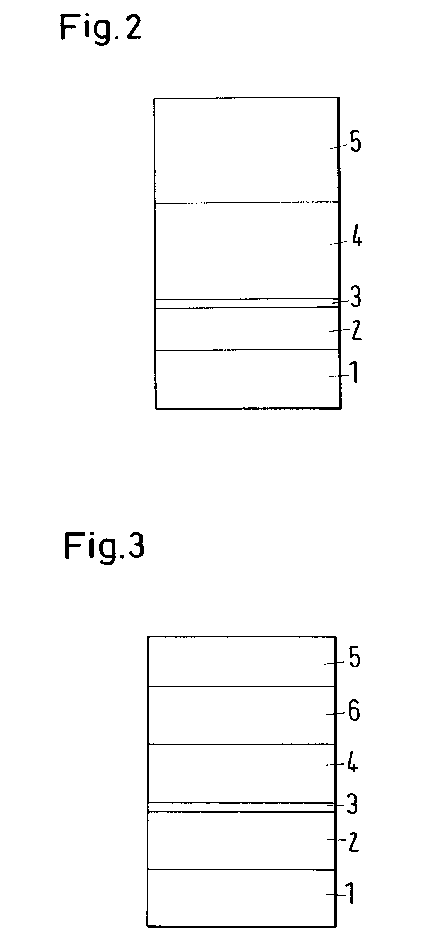

Zur Aufbringung eines Schichtsystems, das vergrössert in Fig. 2 oder Fig. 3 dargestellt ist, wird das Bauteil 1 vorzugsweise auf eine Temperatur von über 800 °C erwärmt. In die Hohlkathode 12 wird durch die Gaseinlassöffnung 15 hindurch das Inertgas 22 eingeführt. Dieses wird aufgrund der in der Hohlkathode 12 herrschenden Spannungsdifferenz in Form einer Glimmentladung ionisiert, wobei die ionisierten Gasatome auf das Kathodenmaterial 13 auftreffen. Dieses ist vorzugsweise ein Reinmetall wie Zirkon, welches in einer vorgegebenen Volumenverteilung mit einem Stabilisatormetall, beispielsweise Yttrium, versetzt ist. Durch die ionisierten Inertgasatome werden aus dem Kathodenmaterial 13 Metallatome und/oder Metallcluster herausgelöst und in dem Inertgasstrom 22 in Richtung des Bauteiles 1 transportiert. Durch den über die Oxidationsmittelzuführung 17 zugeführten Sauerstoff findet eine vollständige Oxidation der Metallatome, insbesondere zur Zirkonoxid und Yttriumoxid, statt. Diese scheiden sich, wenn der Verbindungsweg zum Bauteil 1 geöffnet ist, auf dem Grundkörper 2 des Bauteils 1 in Form einer teilstabilisierten metalloxidkeramischen Wärmedämmschicht 4 ab. Durch eine Rotation des Bauteils 1 um seine Längsachse 25 findet eine gleichmässige Beschichtung des Bauteils 1 statt. Durch eine auf dem Grundkörper 1 aufgebrachte metallische Haftvermittlerschicht 2, aus einem der vorher genannten Materialien, und eine darauf aufgewachsene TGO-Schicht 3, aus einem der vorher genannten Materialien, findet eine thermisch stabile chemische Anbindung des Metalloxids an den Grundkörper 1 statt.

Die Abscheidung des Metalloxids findet in Form der Wärmedämmschicht 4 mit einer feinstrukturierten Stengelstruktur statt. Die gebildeten Keramikstengel sind überwiegend normal zur Oberfläche des Grundkörpers 1 orientiert und haben einen Stengeldurchmesser von im Mittel unter 5,0 µm, insbesondere, wie anhand von Versuchen gezeigt werden konnte, zwischen 0,5 µm und 3,0 µm. Durch diese feinstrukturierte Stengelstruktur mit einem geringen Stengeldurchmesser wird eine besonders hohe Beständigkeit der Wärmedämmschicht 4 gegenüber thermischen Wechselbelastungen mit Temperaturdifferenzen von bis zu über 1000 °C erreicht.

Auf die Wärmedämmschicht 1, die als eine oxidkeramische Schicht ausgebildet ist, folgt eine Deckschicht 5.

Die Erfindung zeichnet sich mithin dadurch aus, dass über ein einfach kontrollierbares und regelbares Verfahren eine thermisch stabile Wärmedämmschicht auf einem metallischen Grundkörper abgeschieden wird. Diese Wärmedämmschicht, welche über ein oder mehrere Zwischenschichten thermomechanisch stabil an den metallischen Grundkörper angekoppelt ist, hat eine feinstrukturierte Stengelstruktur mit einem mittleren Stengeldurchmesser unter 5,0 µm. Vor allem hierdurch wird eine hohe thermische Wechselbeständigkeit der Wärmedämmschicht erreicht, die sich dadurch besonders für die Verwendung bei thermische hoch belasteten Bauteilen, wie einem Heissgas ausgesetzten Komponenten einer Gasturbinenanlage, insbesondere Gasturbinenschaufeln und Brennkammerauskleidungen, eignet.

## Patentansprüche

1. Bauteil, umfassend einen Grundkörper (1), insbesondere einen metallischen Grundkörper, welcher zumindest eine Nickel- und/oder Kobaltbasislegierung umfasst, sowie einem unmittelbar auf dem Grundkörper (1) angeordneten Schichtsystem, umfassend eine Haftvermittlerschicht (2) sowie eine auf der Haftvermittlerschicht (2) angeordnete Wärmedämmschicht, umfassend eine TGO-Schicht (3), insbesondere eine langsam anwachsende Aluminiumoxidschicht und/oder Chromoxidschicht, sowie zumindest eine oxidkeramische Schicht (4), die unmittelbar auf der TGO-Schicht angeordnet ist, und eine auf der oxidkeramischen Schicht (4) angeordnete Deckschicht (5) aus einem A₂E₂O₇ Pyrochlor, wobei A vorzugsweise ein Lanthanid, insbesondere Gadolinium und E vorzugsweise Zirkon, sowie insbesondere Lanthanzirkonat, und/oder eine Perowskitphase umfassen, **dadurch gekennzeichnet, dass** die Schichtdicken der oxidkeramischen Schicht (4), und der Deckschicht (5), zusammen zwischen 50 µm und 2 mm betragen, insbesondere zusammen zwischen 100 µm und 500 µm betragen.

2. Bauteil nach Anspruch 1, wobei die oxidkeramische Schicht (4) eine Zirkonoxidschicht insbesondere eine gradierte Zirkonoxidschicht (6) umfasst und/oder einen Stabilisator, wie insbesondere Yttriumoxid enthält und/oder Zirkonoxid, Hafniumoxid oder ein Mischoxid der beiden Komponenten, das durch Yttriumoxid teilstabilisiert vorliegt.

3. Bauteil nach einem der vorhergehenden Ansprüche, bei dem die Haftvermittlerschicht (2) als metallische oder intermetallische Haftvermittlerschicht ausgebildet ist, die insbesondere eine M₁CrAlY-Legierung enthält, wobei M₁ für zumindest eines der Elemente Eisen, Kobalt, Nickel, Cr für Chrom, Al für Aluminium, Y für Yttrium steht und/oder die Haftvermittlerschicht (2) zumindest eines der Elemente der Seltenen Erden, Hafnium, Tantal, Silizium und/oder ein Metallaluminid enthält, wobei das Metallaluminid NiAl, CoAl, TiAl, NiCrAl, CoCrAl, sowie ein PtM₂Al, wobei M₂ die Elemente Fe, Ni, Co, Cr oder Kombinationen derselben, insbesondere PtNiAl, PtNiCrAl, umfasst.

4. Bauteil nach einem der vorhergehenden Ansprüche, wobei eine erste oxidkeramische Schicht (4) vorgesehen ist, die vorzugsweise eine Dicke im Bereich von 5 bis 50 µm aufweist, sowie eine erste Deckschicht, die vorzugsweise eine Dicke im Bereich von 5 bis 50 µm aufweist, vorgesehen ist, sowie zumindest eine weitere Schichtfolge von einer weiteren oxidkeramischen Schicht (4) und/oder Deckschicht (5) vorgesehen ist.

5. Bauteil nach einem der vorhergehenden Ansprüche, wobei die oxidkeramische Schicht (4) Keramikstengel (5) mit einem Stengeldurchmesser von unter 2,5 µm, insbesondere zwischen 0,5 µm und 2,0 µm, aufweist.

6. Bauteil nach einem der vorhergehenden Ansprüche, wobei die oxidkeramische Schicht (4) Keramikstengel (5) mit einem Stengeldurchmesser in einem Bereich von 2,5 µm bis 50 µm aufweist.

7. Bauteil nach einem der vorhergehenden Ansprüche, welches insbesondere als eine Turbinenschaufel, wie insbesondere eine Leit- oder Laufschaufel einer Gasturbine, oder als eine heissgasbeaufschlagte Komponente einer Gasturbine, insbesondere ein Hitzeschild, ausgebildet ist.

8. Beschichtungsvorrichtung (10) zur Beschichtung eines Grundkörpers (1) mit einem Schichtsystem gemäss Anspruch 1 umfassend
a) eine Halteeinrichtung (11) zur Positionierung des Grundkörpers (1) in einer verschliessbaren Kammer,
b) eine Vakuumerzeugungseinrichtung zur Erzeugung eines Vakuums in der Kammer,
c) zumindest eine Quelle zur Bereitstellung von beschichtungsfähigem Schichtmaterial, wobei insbesondere die Quelle als Kathodenanordnung (12) ausgebildet ist, und
d) einer zusätzlichen separaten Beheizungseinrichtung (16) zur Erwärmung des Grundkörpers (1),
**dadurch gekennzeichnet, dass** die Quelle derart ausgestaltet und angeordnet ist, dass Schichtmaterial mittels eines Inertgasstroms von der Quelle zum Bauteil transportierbar ist.

9. Beschichtungsvorrichtung nach Anspruch 8, wobei die Kathodenanordnung (12) von einem Inertgas durchströmbar ist, und ein Kathodenmaterial (13) abstäubbar ist, wobei das Kathodenmaterial eine Legierung aus Zirkon, sowie insbesondere ein Stabilisatormetall, wie Yttrium, enthält, wobei der Anteil des Stabilisatormetalls so bestimmt ist, dass in der oxidkeramischen Schicht (4) der Anteil des Stabilisatormetalloxids auf einen Bereich von 3,0% bis 12,0%, insbesondere auf einen Bereich von 3,0% bis 8,0%, Gewichtsprozent des Anteils des Zirkonoxids einstellbar ist, wobei eine Oxidationsmittelzuführung (17) für eine Oxidation des abgestäubten Kathodenmaterials ausserhalb der Kathodenanordnung (12) vorgesehen ist, wobei die Quelle eine Anode (14) umfasst, eine der Halteeinrichtung (11) zugewandte Gasauslassöffnung (18) sowie eine Gaseinlassöffnung (15) für Inertgas aufweist.

10. Beschichtungsvorrichtung (10) nach Ansprüchen 8 oder 9, bei der das Kathodenmaterial (13) eine Legierung aus Zirkon, insbesondere mit einem Stabilisatormetall, wie Yttrium, enthält, wobei der Anteil des Stabilisatormetalls so bestimmt ist, dass in der oxidkeramischen Schicht (4) der Anteil des Stabilisatormetalloxids auf einen Bereich von 3,0% bis 12,0%, insbesondere auf einen Bereich von 3,0% bis 8,0%, Gewichtsprozent des Anteils des Zirkonoxids einstellbar ist und eine Oxidationsmittelzuführung (17) für eine Oxidation des Zirkons ausserhalb der Hohlkathodenanordnung (12) vorgesehen ist.

11. Beschichtungsvorrichtung nach einem der Ansprüche 8 bis 10, wobei das Kathodenmaterial ein Lanthanid, insbesondere Gadolinium und/oder Lanthan, und/oder Zirkon enthält, wobei das Verhältnis der Anteile so bestimmt ist, dass in der oxidkeramischen Deckschicht (5) die Zusammensetzung eines Pyrochlors und/oder eines Perowskits einstellbar ist.

12. Beschichtungsvorrichtung nach einem der Ansprüche 8 bis 11, wobei das Kathodenmaterial ein Lanthanid, insbesondere Gadolinium und/oder Lanthan, und/oder Zirkon, insbesondere mit einem Stabilisatormetall, wie Yttrium, enthält, wobei das Verhältnis der Anteile so bestimmt ist, dass in der oxidkeramischen Deckschicht (5) die Zusammensetzung eines Pyrochlors oder eines Perowskits mit Beimischungen eines Stabilisatoroxides, insbesondere Y₂O₃, einstellbar ist.

13. Beschichtungsvorrichtung (10) nach einem der Ansprüche 8 bis 12, bei der die Beheizungseinrichtung (16) für eine Erwärmung des Grundkörpers (1) auf über 800 °C, insbesondere auf 950 ° C bis etwa 1050 °C ausgelegt ist.

14. Beschichtungsvorrichtung (10) nach einem der Ansprüche 8 bis 13, wobei eine Vakuumpumpeinrichtung (20) zur Erzeugung eines Vakuums in einer vakuumdicht verschliessbaren Kammer von unter 1 mbar, insbesondere von 0,3 mbar bis 0,9 mbar vorgesehen ist.

15. Beschichtungsvorrichtung (10) nach einem der Ansprüche 8 bis 14, bei der die Halteeinrichtung (11) beweglich, insbesondere drehbar gelagert ist, sodass eine kontinuierliche Hin- und Herbewegung und/oder Drehung, des Grundkörpers (1) gegenüber der Gasauslassöffnung (18) ermöglicht wird.

16. Verfahren zur Beschichtung eines Grundkörpers (1) mit einem Schichtsystem gemäss Anspruch 1 unter Vakuumbedingungen, wobei ein Inertgas in einer im wesentlichen sauerstofffreien Atmosphäre ionisiert wird, das Inertgas mit einem Kathodenmaterial in Kontakt gebracht wird, wobei das ionisierte Inertgas aus einem Kathodenmaterial, insbesondere einem metallischen und/oder keramischen Kathodenmaterial, Atome und/oder Atomgruppen herauslöst, worauf die aus dem Kathodenmaterial herausgelösten Atome und/oder Atomgruppen mit dem Inertgas in Richtung des Grundkörpers (1) mitgeführt werden und eine metallische und/oder keramische Verbindung auf dem Grundkörper (1) abgeschieden wird, wobei der Grundkörper (1) auf eine vorgegebene Ankeimtemperatur von über 800 °C, insbesondere in einem Bereich zwischen 950 °C und 1050 °C aufgeheizt wird.

17. Verfahren nach Anspruch 16, wobei den Atomen und/oder Atomgruppen vor Erreichen des Grundkörpers (1) Sauerstoff zugeführt wird, so dass sich ein Metalloxid und/oder eine oxidkeramische Verbindung bildet, welche auf dem Grundkörper (1) abgeschieden werden, oder eine metallische und/oder keramische Verbindung auf dem Grundkörper (1) abgeschieden wird und auf dem Grundkörper durch auftreffenden Sauerstoff zu einem Metalloxid oder einer oxidkeramischen Verbindung oxidiert wird.

18. Verfahren nach Anspruch 16, wobei insbesondere ein reaktives Gasflusssputterverfahren und/oder ein reaktives Gasflusssputterverfahren in Kombination mit einem Vakuumbogenverdampfungsverfahren und/oder Hohlkathodenverdampfungsverfahren, und/oder Niedervoltbogenverdampfungsverfahren und/oder Elektronenstrahlverdampfungsverfahren und/oder einem PVD Verfahren, wie insbesondere dem HF-PVD und/oder DC-PVD Verfahren und/oder einem APS und/oder LPPS und/oder TF-LPPS und/oder VPS verwendet wird.
